# DEMANDE DE BREVET EUROPEEN

(11) **EP 0 615 132 A1**
(43) Date de publication de la demande: **14.09.1994**
(21) Numéro de dépôt: 94400495.1
(22) Date de dépôt: 08.03.1994
(51) Int. Cl.: G01R 31/02, G06F 15/60

(54) **Procédé de test électrique de lignes équipotentielles**

(30) Priorité: 12.03.1993 FR 9302866
(71) Demandeur: THOMSON-CSF, 75008 Paris (FR)
(72) Inventeur: Charmoille, Gilles, F-92402 Courbevoie Cedex (FR); Desprin, Didier, F-92402 Courbevoie Cedex (FR)
(74) Mandataire: Benoit, Monique

(57) **Abrégé**

L'invention concerne un procédé de test électrique de lignes équipotentielles.

Chaque ligne (L1, L2, L3, L4, L5, L6, L7) étant parcourue par au moins deux points de test, au moins une ligne de coupure (Lc) sépare les points de test. Les points de test d'un premier côté (1) de la ligne de coupure (Lc) sont regroupés dans un premier ensemble (E₁) et les points de test de l'autre côté (2) sont regroupés dans un deuxième ensemble (E₂), les points de test de la ligne de coupure (Lc) appartenant aux deux ensembles (E₁, E₂). Le test électrique est effectué dans une première étape entre les points de test du premier ensemble (E₁) et dans une deuxième étape entre les points du deuxième ensemble (E₂), des points de test du premier ensemble (E₁) étant regroupés dans le deuxième ensemble (E₂), tout en restant dans le premier ensemble, pour assurer la continuité du test électrique entre les points de test des deux ensembles (E₁, E₂).

Application : Tests de continuité ou d'isolement électriques de coffrets électriques notamment.

## Description

L'invention concerne un procédé de test électrique de lignes équipotentielles. L'invention s'applique notamment au test de continuité ou d'isolement électrique de tiroirs de câblage, de paniers à cartes, de coffrets électriques ou de circuits imprimés par exemple. Plus généralement, elle s'applique au test de tous matériels dont il faut vérifier la continuité ou l'isolement électrique des lignes équipotentielles.

Les matériels électriques, électroniques ou informatiques tels que des calculateurs par exemple, comportent un nombre croissant de circuits. imprimés, mais aussi de composants complexes possédant un nombre de plus en plus grand d'entrées/sorties. Il en résulte un nombre croissant de lignes équipotentielles reliant ces entrées/sorties. Les composants ou les cartes étant en relation avec d'autres composants ou cartes, ces équipotentielles transitent à travers des connecteurs reliant par exemple les cartes entre-elles par l'intermédiaire d'un fond de panier ou de coffrets. Ces derniers comportent donc de nombreuses équipotentielles de liaison. Une condition nécessaire au bon fonctionnement des matériels est la continuité électrique des équipotentielles en jeu ainsi que l'isolement galvanique entre elles;

Il existe des appareils pour tester cette continuité et cet isolement. Ces derniers sont reliés à des points de test situés généralement au niveau des connecteurs. Par l'intermédiaire de ces liaisons, ils testent successivement des tronçons d'équipotentielles situés entre des points de test.

Or, les tests de continuité et d'isolement électriques des matériels précités nécessitent un nombre croissant de points de test, par exemple supérieur à 8000, au point d'atteindre les capacités maximum des testeurs actuels. Il est possible d'accroître les capacités de ces derniers mais au prix d'un surcoût, d'une complexité et d'un encombrement important.

Le but de l'invention est d'éviter cet inconvénient, notamment en permettant de prendre en compte avec les testeurs actuels, un grand nombre de points de test, par exemple supérieur à l'ordre de grandeur précité, donc sans complexifier ces derniers. A cet effet l'invention a pour objet un procédé de test électrique de lignes équipotentielles, chaque ligne étant parcourue par au moins deux points de test, caractérisé en ce qu'au moins une ligne de coupure séparant les points de test, les points de test d'un premier côté de la ligne de coupure étant regroupés dans un premier ensemble et les points de test de l'autre côté étant regroupés dans un deuxième ensemble, les points de test de la ligne de coupure appartenant aux deux ensembles, le test électrique est effectué dans une première étape entre les points de test du premier ensemble et dans une deuxième étape entre les points de test du deuxième ensemble, des points de test du premier ensemble étant regroupés dans le deuxième ensemble, tout en restant dans le premier ensemble, pour assurer la continuité du test électrique entre les points de test du premier ensemble et les points de test du deuxième ensemble.

L'invention a pour principaux avantages qu'elle s'adapte au test de continuité et d'isolement électrique de tous types de matériels électriques, électroniques ou informatiques, qu'elle s'adapte à tous type de testeurs, qu'elle est simple à mettre en oeuvre et qu'elle est économique.

D'autres caractéristiques et avantages de l'invention apparaîtront à l'aide de la description qui suit faite en regard de dessins annexés qui représentent:

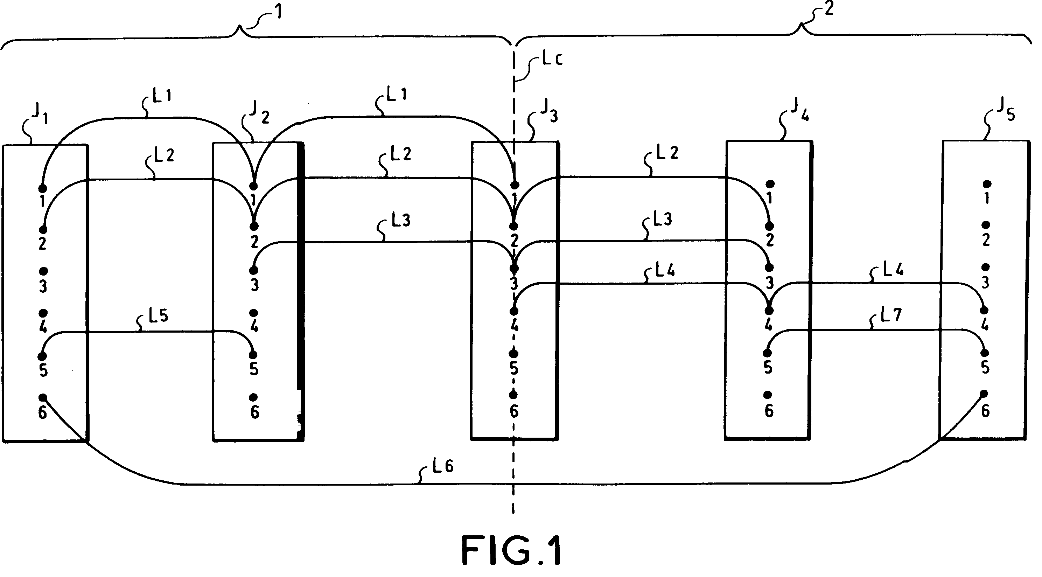

- les figures 1, 2 et 3, des exemples illustratifs d'ensembles de lignes électriques équipotentielles et de points de test.

La figure 1, présente un exemple illustratif d'ensemble de lignes électriques équipotentielles L1, L2, L3, L4, L5, L6, L7. Ces lignes passent par des connecteurs J1, J2, J3, J4, J5 ordonnés selon une relation dépendant par exemple de leurs positions relatives. Les lignes sont parcourues chacune par des points de test. Ceux-ci correspondent par exemple à des bornes des connecteurs par lesquelles elles passent, les tests électriques étant notamment plus aisés en ces endroits. Dans ce cas, chaque point test est repéré par exemple par le numéro d'orde de son connecteur et par le numéro d'ordre de sa borne correspondante dans le connecteur. Dans la figure 1, un connecteur de rang i étant noté Ji, un point test sur une borne de rang j à l'intérieur de ce connecteur est par exemple noté Ji/j. Ainsi, dans l'exemple de configuration de la figure 1, une première ligne équipotentielle relie la première borne J1/1 d'un premier connecteur J1, à la première borne J3/1 d'un troisième connecteur J3 en passant par la première borne J2/1 d'un deuxième connecteur J2. Une deuxième ligne L2 relie la deuxième borne J1/2 du premier connecteur J1 à la deuxième borne J4/2 d'un quatrième connecteur J4 en passant par la deuxième borne J2/2 du deuxième connecteur J2 puis par la deuxième borne J3/2 du troisième connecteur J3. Une troisième ligne L3 relie la troisième borne J2/3 du deuxième connecteur J2 à la troisième borne J4/3 du quatrième connecteur J4 en passant par la troisième borne J3/3 du troisième connecteur J3. Une quatrième ligne L4 relie la quatrième borne J3/4 du troisième connecteur J3 à la quatrième borne J5/4 d'un cinquième connecteur J5 en passant par la quatrième borne J4/4 d'un quatrième connecteur J4. Une cinquième ligne L5 relie la cinquième borne J1/5 du premier connecteur J1 à la cinquième borne J2/5 du deuxième. connecteur J2. Une sixième ligne L6 relie la sixième borne J1/6 du premier connecteur J1 à la sixième borne J5/6 du cinquième connecteur J5. Une septième ligne L7 relie la cinquième borne J4/5 du quatrième connecteur J4 à la cinquième borne J5/5 du cinquième connecteur J5.

Les bornes des connecteurs appartenant à des lignes équipotentielles, correspondent par exemple à des points de test. Une ligne de coupure Lc passe par exemple par les bornes du troisième connecteur J3. Les points de test situés d'un premier côté 1 de la ligne de coupure Lc, comprenant par exemple des points du premier connecteur J1, sont regroupés dans un premier ensemble E₁. Les points de test situés de l'autre côté 2 de la ligne de coupure Lc sont regroupés dans un deuxième ensemble E₂, les points de test J3/1, J3/2, J3/3 de la ligne de coupure appartenant aux deux ensembles E₁, E₂. Un point de test J1/6 isolé dans le premier côté 1 mais relié à une équipotentielle L6 chevauchant la ligne est regroupé uniquement dans le deuxième ensemble E₂.

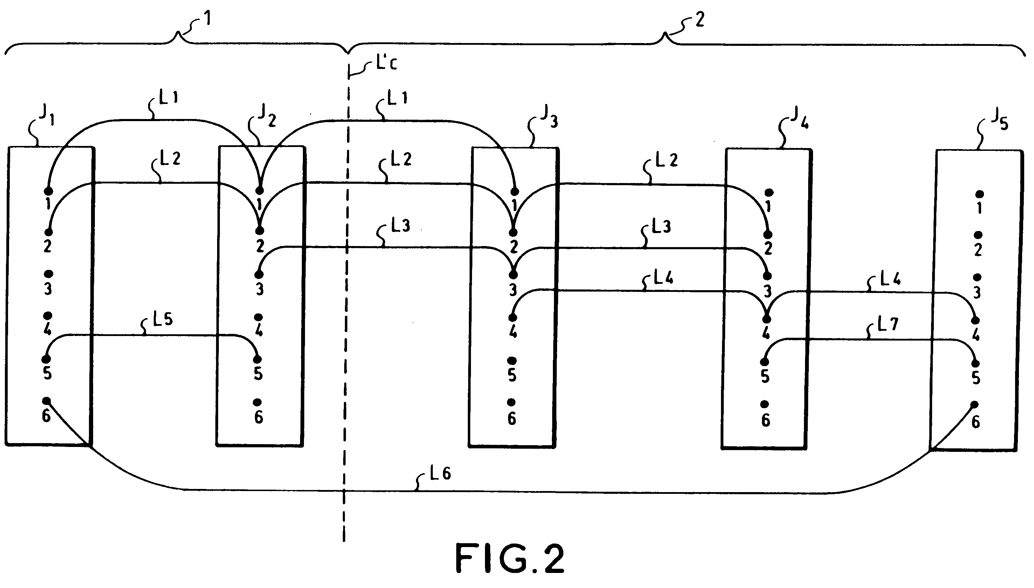

La ligne de coupure peut ne pas passer par des points de test et simplement séparer les points test en croisant des équipotentielles comme l'illustre une ligne de coupure L'c de la figure 2 qui croise les première L1, deuxième L2, troisième L3 et sixième L6 lignes équipotentielles sans rencontrer des points de tests.

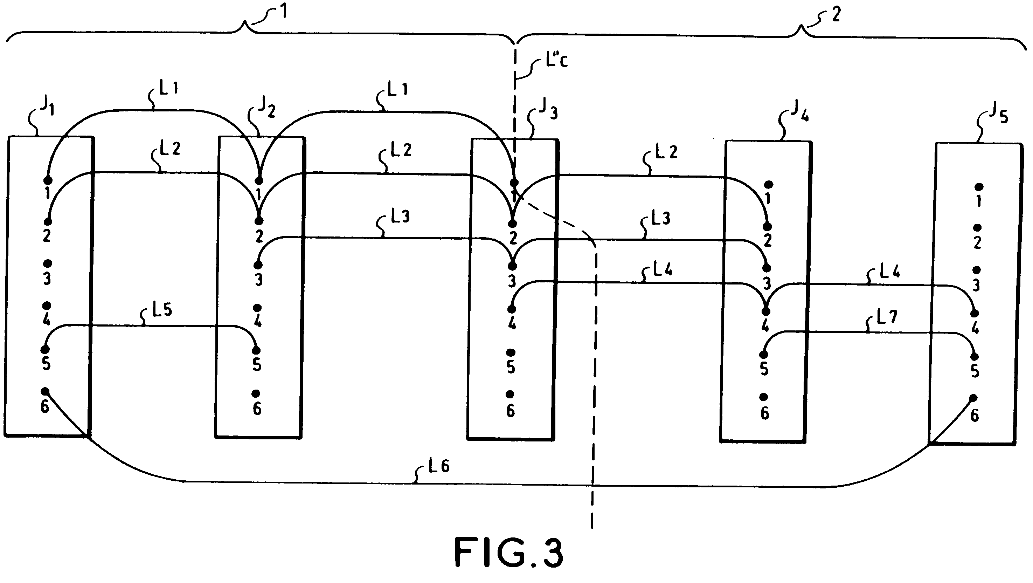

La figure 3 présente une autre ligne de coupure L''c passant par un seul point de test, la première borne J3/1 du troisième connecteur J3, et croisant les deuxième L2, troisième L3, quatrième L4 et sixième L6 lignes équipotentielles.

Selon le test électrique à effectuer, continuité électrique des lignes équipotentielles ou isolation de ces dernières entre-elles, différents points de test du premier ensemble E₁ sont ajoutés dans le deuxième ensemble E₂ tout en restant à la fois dans le premier ensemble E₁, ce dernier restant par exemple inchangé quelque soit le type de test à effectuer.

Dans une première étape, le test électrique est par exemple effectué entre les points de tests du premier ensemble E₁. Ce test peut être un test de continuité électrique entre des points de test successifs de chacune des équipotentielles parcourues par les points de test du premier ensemble E₁, le test étant limités aux points de tests de ce dernier.

Ce test peut être aussi celui de l'isolement galvanique des points. de test appartenant à des lignes équipotentielles différentes.

La première étape pourrait tout aussi bien être effectuée sur le deuxième ensemble E₂. Le test électrique peut être réalisé par tous types de testeurs.

La ligne de coupure Lc, illustrée par la figure 1, est par exemple positionnée de façon à ce que le premier ensemble E₁ comporte un nombre de points de tests proche du maximum de capacité du testeur utilisé, ce nombre étant au plus égal à ce maximum.

Dans une deuxième étape, le test électrique est effectué sur les points de test de l'ensemble restant, E₂ par exemple. Des points de test du premier ensemble E₁ sont aussi inclus dans le deuxième ensemble E₂, notamment pour assurer la continuité du test électrique entre les points de test du premier ensemble E₁ et les points de test du deuxième ensemble E₂.

Ainsi, dans le cas par exemple de test de continuité électrique, si une liaison entre un connecteur de rang inférieur à celui du lieu de la ligne de coupure Lc et un connecteur de rang supérieur à celui du lieu de la coupure, comme par exemple la sixième ligne équipotentielle L6 entre le premier connecteur J1 et le cinquième connecteur J5, toutes les bornes du connecteur de rang inférieur, le premier connecteur J1 par exemple, appartenant à des équipotentielles reliées à des points de test du deuxième ensemble E₂ sont ajoutées dans ce dernier. Dans l'exemple de la figure 1, les première, deuxième et sixième bornes J1/1, J1/2, J1/6 du premier connecteur J1 sont ajoutées dans le deuxième ensemble E₂, car la première borne J1/1 appartient à la première ligne équipotentielle L1 reliée à la première borne J3/1 du troisième connecteur qui appartient au deuxième ensemble E₂, la deuxième borne J1/2 appartient à la deuxième ligne équipotentielle L2 qui est reliée aux deuxièmes bornes J3/2, J4/2 des troisième et quatrième connecteurs J3, J4, lesquelles appartiennent au deuxième ensemble E₂, et enfin la sixième borne J1/6 appartient à la sixième ligne équipotentielle L6 reliée à la sixième borne J5/6 du cinquième connecteur, laquelle appartient au deuxième ensemble. Pour le test de continuité électrique, et toujours suivant l'exemple de la figure 1, les contenus des ensembles E₁ et E₂ sont au moins constitués des bornes ou point de test:
J1/1, J1/2, J1/5, J1/6, J2/1, J2/2, J2/3, J2/5, J3/1, J3/2, J3/3
Pour le premier ensemble E₁.
J3/1, J3/2, J3/3, J3/4, J4/2, J4/3, J4/4, J4/5, J5/4, J5/5, J5/6, J1/1, J1/2, J1/6 pour le deuxième ensemble E₂.
Pour chaque ensemble, les tests de continuité électrique sont par exemple effectués successivement entre des points de test d'une même ligne équipotentielle.

De façon générale, donc y compris dans le cas où les points de test ne font pas partie d'un connecteur, les points du premier côté 1 de la ligne de coupure et appartenant donc au premier ensemble E₁, sont aussi regroupés dans le deuxième ensemble E₂ s'ils sont en liaison directe avec un point de test du deuxième côté, c'est à dire appartenant au deuxième ensemble E₂, une liaison directe signifiant qu'il n'y a pas de point de test de la ligne équipotentielle entre les deux points en liaison.

Dans un cas où les points de test appartiennent à des connecteurs, le test électrique peut se faire entre connecteurs par exemple, notamment pour une plus grande facilité de mise en oeuvre des tests, c'est à dire que pour un connecteur donné, ses points sont successivement testés avec les points des autres connecteurs, ces derniers étant pris séparément.

Ainsi dans ce cas, comme cela a été précédemment mentionné, si une borne d'un connecteur du premier côté 1 de la ligne de coupure est reliée directement par une ligne équipotentielle à un connecteur du deuxième côté, alors toutes les bornes du connecteur du premier côté reliées par une ligne équipotentielle, directement ou non à un connecteur du deuxième côté sont regroupées dans le deuxième ensemble E₂, tout en restant dans le premier ensemble E₁ regroupant les points de test du premier côté 1. Un point de test qui appartient à la ligne de coupure Lc appartient aux deux côtés, de même un connecteur dont la ligne de coupure passe par ses bornes appartient aux deux côtés.

Dans le cas de test d'isolement entre des points de test ou des lignes équipotentielles, l'ajout de points du premier ensemble E₁ vers le deuxième ensemble E₂ est par exemple effectué différemment. Dans ce cas, lorsqu'aucun des points de test d'une ligne équipotentielle n'appartiennent au deuxième côté 2 ou au deuxième ensemble E₂, la cinquième ligne L5 par exemple dans le cas de la figure 1, un de ses points de test est ajouté à ce deuxième ensemble et est testé comme un point non connecté à une ligne équipotentielle donc testé en isolement par rapport aux autres points du. deuxième ensemble E₂. Dans l'exemple de la figure 1, ce point de test ajouté est par exemple la cinquième borne J1/5 du premier connecteur appartenant à la cinquième ligne équipotentielle L5. Cette borne J1/5 est testée comme un point non connecté à une ligne équipotentielle, donc testée en isolement par rapport aux autres points du deuxième ensemble E₂, notamment aux points J4/5 et J5/5 de la septième ligne équipotentielle L7, ce qui permet de tester l'isolement de cette dernière avec la cinquième ligne équipotentielle L5. Tous les points de test de chaque ensemble, non connectés à des lignes équipotentielles sont par exemple testés en isolements par rapport à tous les autres points de test de l'ensemble auquel il appartient.

Le deuxième ensemble E₂ peut être constitué de manière à assurer à la fois un test de continuité électrique et un test d'isolement électrique. Cependant dans un tel cas il comporte plus de points que s'il était destiné uniquement à l'un ou l'autre de ces test. Les différentes constitutions possibles sont donc définies notamment en fonction des capacités des moyens de test.

Dans le cas où les deux ensembles E₁ et E₂ possèdent encore chacun par exemple un trop grand nombre de points de test, les côtés 1, 2 associés à ceux-ci peuvent à nouveau être chacun coupés par une ligne de coupure selon le procédé précédemment décrit, pour générer deux nouveaux ensembles, lesquels peuvent à nouveau être coupés pour générer deux autres nouveaux ensemble, et ainsi de suite, notamment jusqu'à ce que les ensembles possèdent un nombre de points de test compatibles de moyens de test disponibles.

## Revendications

1. Procédé de test électrique de lignes équipotentielles (L1, L2, L3, L4, L5, L6, L7), chaque ligne étant parcourue par au moins deux points de test, au moins une ligne de coupure séparant les points de test, les points de test d'un premier côté (1) de la ligne de coupure (Lc) étant regroupés dans un premier ensemble (E₁) et les points de test de l'autre côté (2) étant regroupés dans un deuxième ensemble (E₂), les points de test de la ligne de coupure (Lc) appartenant aux deux ensembles (E₁, E₂), le test électrique étant effectué dans une première étape entre les points de test du premier ensemble (E₁) et dans une deuxième étape entre les points de test du deuxième ensemble (E₂), caractérisé en ce qu'un point de test du premier côté (1) étant relié directement par une ligne équipotentielle (L6) à un point de test du deuxième côté est regroupé dans le deuxième ensemble (E₂) tout en restant dans le premier ensemble (E₁) et en ce qu'aucun des points d'une équipotentielle (L5) n'appartenant au deuxième ensemble (E₂), un des points (J1/5) de cette équipotentielle est ajouté dans le deuxième ensemble (E₂) tout en restant dans le premier ensemble (E₁).

2. Procédé selon la revendication 1, caractérisé en ce que les points de test étant des bornes de connecteurs, si une borne (J1/6) d'un connecteur (J1) du premier côté (1) est reliée directement par une ligne équipotentielle (L6) à une borne (J5/6) d'un connecteur (J5) de l'autre côté (2), alors toutes les bornes (J1/1, J1/2, J1/6) de ce connecteur (J1) reliées par une équipotentielle (L1, L2, L6) à un connecteur du deuxième côté (2) sont regroupées dans le deuxième ensemble (E₂) tout en restant dans le premier ensemble (E₁), un connecteur (J3) dont la ligne de coupure (Lc) passe par ses bornes appartenant aux deux côtés (1, 2).

3. Procédé selon l'une quelconque des revendications précédentes, caractérisé en ce que le test électrique étant effectué par des moyens de test pouvant traiter un maximum de points de test donné, la ligne de coupure (Lc) est placée de façon à ce que le nombre de points de test du premier ensemble (E₁) soit égal au plus au maximum donné.

4. Procédé selon l'une quelconque des revendications précédentes, caractérisé en ce que les deux côtés (1, 2) sont chacun coupés par une nouvelle ligne de coupure, une nouvelle ligne de coupure séparant les points de test, les points de test d'un premier côté étant regroupé dans un premier nouvel ensemble et les points de test de l'autre côté étant regroupés dans un deuxième nouvelle ensemble, un test électrique étant effectué entre les points de test de chacun des ensembles, les points de test de la ligne de coupure appartenant aux deux ensembles, des points de test du premier ensemble étant regroupés dans le deuxième ensemble pour assurer la continuité du test électrique entre les points de test des deux ensembles.

5. Procédé selon l'une quelconque des revendications précédentes, caractérisé en ce que le test électrique est un test de continuité électrique entre les points de test.

6. Procédé selon l'une quelconque des revendications précédentes, caractérisé en ce que le test électrique est un test d'isolement électrique entre les points de test.
